# EUROPEAN PATENT APPLICATION

(11) **EP 1 918 996 A2**
(43) Date of publication of application: **07.05.2008**
(21) Application number: 07020716.2
(22) Date of filing: 23.10.2007
(51) Int. Cl.: H01L 27/28, H01L 27/32

(54) **Picture element driving circuit of display panel and display device using the same**

(30) Priority: 31.10.2006 JP 2006295667
(71) Applicant: Hitachi, Ltd., Chiyoda-ku Tokyo 100-8280 (JP)
(72) Inventor: Fujimori, Masaaki, Chiyoda-ku Tokyo 100-8220 (JP); Shiba, Takeo, Chiyoda-ku Tokyo 100-8220 (JP); Ando, Masahiko, Chiyoda-ku Tokyo 100-8220 (JP); Kawasaki, Masahiro, Chiyoda-ku Tokyo 100-8220 (JP); Hashizume, Tomihiro, Chiyoda-ku Tokyo 100-8220 (JP)
(74) Representative: Strehl Schübel-Hopf & Partner

(57) **Abstract**

The present invention provides a picture element driving circuit of an active matrix display device, with a configuration of no through-holes, including two or more FETs. A display device of the present invention has a structure in which a first field-effect transistor (213) and a second field-effect transistor (211) are provided, insulation films of the first and second field-effect transistor are formed on the same layer, and semiconductors used as channels of the two field-effect transistors are formed on both surfaces of the insulation film, respectively. The display device has an electric circuit of a structure in which one of source/drain electrodes of the first field-effect transistor (311) is used as a gate electrode of the second field-effect transistor.

## Description

### FIELD OF THE INVENTION

The present invention relates to a picture element driving circuit of a display panel and a display device using the same, and particularly to a picture element driving circuit and a display device using the same having a structure in which a driving circuit can be configured only by laminating layers including elements for configuring a circuit, such as wires and constituent elements of an FET such as source, drain and gate electrodes, an insulation film and a semiconductor, and in which through-holes for connecting the layers are not required, in a configuration of the picture element driving circuit in which a driving circuit for one picture element is configured by using two field-effect transistors (FETs).

### BACKGROUND OF THE INVENTION

A cathode-ray tube display device uses an electron gun for lighting of a picture element. On the other hand, a plasma display panel (PDP) and a liquid crystal display (LCD) that are typical thin-model display devices use thin film transistors (TFTs), in place of the electron gun, for lighting and turning off of a picture element. The TFTs are arranged in all the picture elements to be used as switching elements so as to perform lighting control of the picture elements. Therefore, each picture element is provided with a circuit (picture element driving circuit), including the TFT, for controlling lighting of the picture element. For the TFT, an element using amorphous silicon or polycrystalline silicon as a material of a channel is used, and the TFT is manufactured by a method similar to that of manufacturing a large-scale integrated circuit (LSI).

The LSI is configured by laminating a plurality of thin films. Each layer includes the FET and wires that are constituent elements of the LSI. The FET is configured in such a manner that source/drain electrodes and a gate electrode, a gate insulation film, and a channel semiconductor are formed on different layers, and the layers are laminated while being aligned. The layers are etched to form the structure by photolithography, and are sequentially laminated from the bottom. Electrical connection of the layers includes a case in which electrically-direct contact is realized between two contacted layers that are adjacent in the upper and lower sides to each other such as connection in the FET, and a case in which holes across the plurality of layers are provided by photolithography and metals are embedded therein. The latter case is called through-holes, and the holes are formed by photolithography. Etching is required for hole-drilling, and a dry etching process such as reactive ion plasma etching is usually used.

Such a manufacturing process of LSI requires an exposure device used for photolithography and a vacuum device used for thin-film manufacturing and dry etching, which results in high cost. Accordingly, if the picture element driving circuit of the thin-model display device can be manufactured at low cost by a method different from the manufacturing process of LSI, the cost of LSI and also the cost of a product using the LSI can be reduced due to reduction in manufacturing cost.

As a method of reducing the manufacturing cost, a manufacturing method of the TFT and an electric circuit by coating and printing is currently being actively studied. The manufacture by coating and printing does not require a vacuum device indispensable in a silicon device and a heat treatment at a high temperature, so that significant reduction in manufacturing cost can be realized. On the other hand, it is difficult to miniaturize a circuit by coating and printing as compared to photolithography, and thus the coating and printing cannot be used for the manufacturing of the LSI.

However, since demands for miniaturization of a circuit and performance of the TFT in the picture element driving circuit of the thin-model display device are low as compared to LSI, there is a possibility that a circuit forming method using the coating/printing method can be applied. Since organic materials are soluble with an organic solvent and can be handled at a low temperature around room temperature, they are suitable for the coating/printing method. If a channel semiconductor and an insulation film of the TFT can be configured by organic materials, all the forming processes of TFT can be realized by the coating/printing method.

For example, manufacturing of a single FET element by the coating/printing method is described in Nature Materials, Vol. 3, pp. 171-176 (2004). In addition, an approach to formation of an active matrix control picture element driving circuit by the coating/printing method is described in Nature Materials, Vol. 3, pp. 106-110 (2004), Society for Information Display 2005 International Symposium 2005, pp. 19-21 (2005), Applied Physics Letters, Vol. 85, No. 10, pp. 1849-1851 (2004), and Advanced Materials, Vol. 13, No. 21, pp. 1601-1605 (2001). All of the driving circuits described in these documents are driving circuits for voltage-driven picture elements such as LCD, and there are no descriptions that driving circuits for current-driven picture elements are formed by the coating/printing method. In the case of voltage-driven picture elements, the number of TFT necessary for the picture element driving circuit is one, so that there is no need of through-holes in the circuit formation and the circuit can be easily formed by the coating/printing method.

An organic EL (Electro Luminescence) element has attracted attention as an element for the next-generation display panel which can improve faults of PDP and LCD, such as life duration, contrast, responsiveness, and power consumption, and studies toward the practical use have been advanced. The organic EL element is a thin film element of an organic material, and can be made much thinner than PDP and LCD. Further, the organic EL element uses an organic material as a raw material, so that a wall-hanging display and a flexible display can be realized by taking advantage of the characteristics of the organic material such as light weight and plastic properties. Further, as described above, since the organic material is a material suitable for the coating/printing method, there is an advantage that a novel display panel with high added-value can be realized at low cost if the organic EL element and the picture element driving circuit can be realized by the coating/printing method.

The organic EL element is a current-driven element. In the case of using the organic EL element as a picture element, an FET for current control is required in addition to that for picture element switching as described in Japanese Patent No. 2784615, and it is conceived that at least two FETs are required in the picture element driving circuit.

### SUMMARY OF THE INVENTION

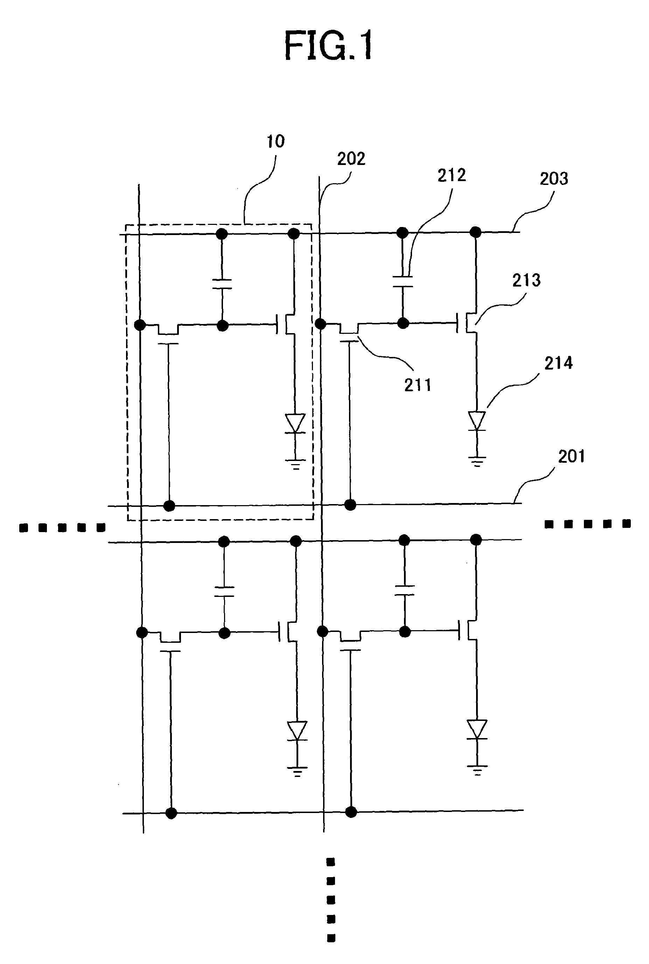

An example of a basic picture element driving circuit of an organic EL element according to the present invention is shown in Fig. 1. In Fig. 1, the reference numeral 10 denotes picture element driving unit circuit of active matrix driving circuit, and this unit circuit is provided in the X-Y directions. In the picture element driving unit circuit 10, there is provided a scanning line 201, a data line 202, a current supplying line 203, a switch FET 211, a holding capacity 212, a driving FET 213, and an organic EL element 214. A ground terminal of the organic EL element 214 is a ground electrode that is commonly used for all elements, and a terminal connected to the driving FET 213 is a counter electrode of each picture element.

Data of the data line 202 is taken in by the switch FET 211 located on a line selected by the scanning line 201 to be held into the holding capacity 212, a signal in accordance with the data of the data line 202 is held for a predetermined period of time, and the signal is applied to a gate of the driving FET 213. A current is supplied or not supplied from the current supplying line 203 to the organic EL element 214 in accordance with the data held by the holding capacity 212, and thus contrasting of each picture element is controlled.

As shown in Fig. 1, the picture element driving unit circuit 10 of the organic EL element has a structure in which one of the source/drain electrodes of one switch FET 211 corresponding to the scanning line is connected to the gate electrode of the driving FET 213 corresponding to the picture element. In the case of manufacturing an LSI on an Si substrate by photolithography, a channel of the FET is formed using the Si substrate, so that even when a plurality of FETs are present, all channels of the FETs are formed on the same layer. This is similar to the case of the picture element driving circuit, and in the picture element driving circuit of the organic EL element, different layers need to be connected to each other so as to connect the source/drain electrodes to the gate electrode. Such a structure is realized by using through-holes in photolithography.

In the case of configuring a circuit by the coating/printing method, a technique of forming the circuit structure by laminating materials is basically employed, which does not include a technique of scraping off substances on the substrate. Therefore, it is difficult to form through-holes by the coating/printing method. The through-holes can be principally formed if the coating/printing method is repeated so as to leave holes at positions of the through-holes. However, this scheme is not practical in consideration of the required sizes and accuracy of alignment of the through-holes. In Advanced Materials, vol. 13, No. 21, pp. 1601-1605 (2001), there is disclosed a method in which after laminating necessary layers, a solvent for a material configuring layers in which the through-holes are provided is locally coated so as to form the through-holes by coating/printing method.

However, this method does not solve the problem of the accuracy of alignment. The width of a wire used for the picture element driving circuit of the display device is normally several tens of micrometers, and it is difficult, even for a device that is still being studied and capable of aligning with high accuracy, to form the through-holes with accuracy in accordance with the width. Further, since an organic material is used as a solvent, a material used for a foundation layer and a top layer is restricted so that the organic solvent does not affect layers other than the through-holes-formed layers. The layers in which the through-holes need to be formed require characteristics, such as electric insulation properties, chemical-resistance properties, water-resistance properties, and gas barrier properties, and a material insoluble with chemicals generally exhibits a higher performance than a material soluble with chemicals due to such characteristics, thus it is difficult to select a material from this aspect.

Accordingly, in the method according to Advanced Materials, vol. 13, No. 21, pp. 1601-1605 (2001), it is necessary to select a film made of a material with low performance, and as a result, there is a possibility that the performance of the FET remains low and the material cannot be used for the FET for the picture element driving circuit. In addition, it is conceivable that usage of a film without sufficient barrier properties results in deterioration of the element earlier than the required life duration of the element. Furthermore, the organic thin films are low in adhesion between the films and mechanical strength as compared to inorganic materials, and thus local peeling and reduction in mechanical strength are caused around the through-holes, resulting in acceleration of deterioration of the element.

As described above, in the case of manufacturing the picture element driving circuit for the organic EL element by the coating/printing method, the formation of through-holes involves serious problems in both aspects of manufacturing and performance. Accordingly, it is absolutely necessary to devise so as to avoid difficulty of the accuracy of alignment in the formation of through-holes, restriction of selecting a material accompanied by usage of a solvent, and acceleration of reduction and deterioration in element performance due to presence of through-holes. The object of the present invention is to solve such problems.

The present invention has been achieved by paying attention to the fact that a picture element is controlled by two FETs and that a channel of the FETs is controlled by a gate electrode that is arranged through an insulation layer. That is, attention has been paid to the fact that the channel of two FETs and the gate thereof are configured while being faced to each other through the insulation layer. Specifically, a gate and a drain of each FET are formed on a layer that is arranged through the insulation layer, and the gate of each FET is arranged on a layer different from the layer on which a source and a drain of the other FET are formed.

These and other objects and many of the attendant advantages of the invention will be readily appreciated as the same becomes better understood by reference to the following detailed description when considered in connection with the accompanying drawings.

### BRIEF DESCRIPTION OF THE DRAWINGS

Fig. 1 is a view showing an example of a basic picture element driving circuit of an organic EL element according to the present invention;
Fig. 2A is a view showing a configuration of a circuit of a first embodiment mainly composed of switch FETs 211;
Fig. 2B is a view explaining a manufacturing procedure of the circuit of the first embodiment mainly composed of the switch FETs 211;
Fig. 2C is another view explaining a manufacturing procedure of the circuit of the first embodiment mainly composed of the switch FETs 211;
Fig. 3A is a view showing a configuration of the circuit of the first embodiment mainly composed of driving FETs 213 that are configured on an insulation film 315;
Fig. 3B is a view explaining a manufacturing procedure of the circuit of the first embodiment mainly composed of the driving FETs 213 that are configured on the insulation film 315;
Fig. 3C is another view explaining a manufacturing procedure of the circuit of the first embodiment mainly composed of the driving FETs 213 that are configured on the insulation film 315;
Fig. 4 is a plan view displaying all of a wiring pattern of picture element driving circuit and counter electrodes according to the first embodiment on a plane surface while paying attention thereto;
Fig. 5 is a schematic view of a completed display device, as a cross section that is viewed at a position corresponding to Fig. 3B;
Fig. 6 is a view showing a method of connecting the picture element driving circuit to peripheral circuits;
Fig. 7 is a time chart explaining an operation of the driving circuit;
Fig. 8 is a schematic cross sectional view showing a configuration of a second embodiment corresponding to that of the first embodiment shown in Fig. 5; and
Fig. 9 is a view showing an example of a pattern of the insulation film 315 of a third embodiment.

### DETAILED DESCRIPTION OF THE PREFERRED EMBODIMENTS

### (First embodiment)

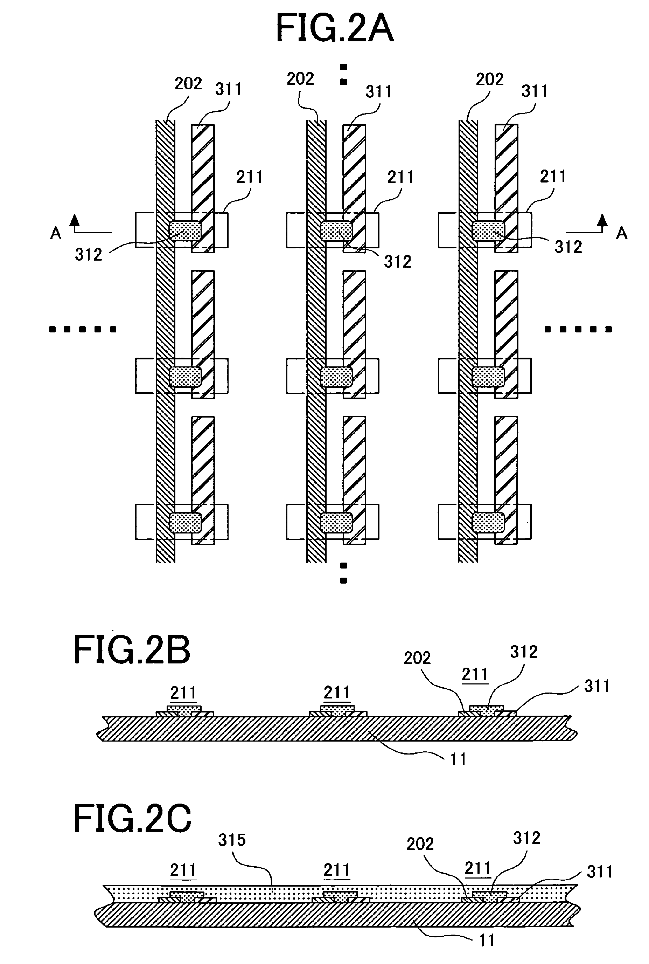

In the first embodiment, a configuration and a manufacturing procedure of a picture element driving circuit shown in Fig. 1 will be described. Figs. 2A, 2B, and 2C are views, each explaining a configuration and a manufacturing procedure of a circuit mainly composed of switch FETs 211.

As shown in Fig. 2A, data lines 202, each having a width of about 50µm, are formed on a quartz substrate 11 with predetermined intervals by using a discharger (not shown). Each interval between the data lines 202 preferably corresponds to the size of a picture element. As an ink discharged from the discharger, a silver ink obtained by mixing silver particles with an organic solvent is used. As will be described below, the data lines 202 also are used as source electrodes of the switch FETs 211 corresponding to scanning lines. Wires 311, each having a width of 50µm, are formed in parallel to the data lines 202 while being apart from the data lines 202 by predetermined intervals. The interval between each data line 202 and each wire 311 is set to 20µm. As will be described below, the wires 311 are used as drain electrodes of the switch FETs 211 corresponding to the scanning lines, and also are used as gate electrodes of driving FETs 213. The length of each wire 311 is set in such a manner that, as will be described below, one end of each wire 311 overlaps a pattern of a current supplying line 203 in order to form holding capacities 212. The switch FETs 211 corresponding to the scanning lines are formed by dropping coatable organic semiconductors 312 that form channels, each having a predetermined spread, of the switch FETs 211 corresponding to the scanning lines at areas where the data lines 202 and the wires 311 are formed in parallel. For gate electrodes of the switch FETs 211, the explanation will be made below.

Fig. 2B is a cross sectional view that is viewed in the arrow direction at the A-A position of Fig. 2A. On the quartz substrate 11, the data lines 202 and the wires 311 are periodically formed in parallel, and the organic semiconductors 312 are dropped so as to cross the both lines. As the organic semiconductors 312, polythiophene dissolved with chloroform is dropped by the discharger in the first embodiment. At a stage prior to dropping of the semiconductors, areas corresponding to channel widths of silver surfaces of the data lines 202 and the drain electrodes 311 are modified with thiol monomolecular films, so that the dropped semiconductor solutions can be effectively kept in the areas used as channels, and a contact resistance between the organic semiconductor and the source/drain electrodes can be effectively reduced. Further, prior to coating of the organic semiconductors, the areas used as channels are treated with an HMDS (Hexamethyldisilazane) solution or with an OTS (Octadecyltrichlorosilane) solution, so that characteristics of the switch FETs 211 can be improved.

Fig. 2C is a cross sectional view that is viewed in the arrow direction at the A-A position of Fig. 1A after the structure shown in Fig. 2B is completed and the whole surface is coated with an insulation film 315. In the first embodiment, the whole surface is coated with a coating polyimide (CT4112 manufactured by KYOCERA Chemical Corporation), as the insulation film 315, that can be formed by burning at a low temperature by spin coating at 8000 rpm. Thereafter, the resultant is heat-treated in a nitrogen atmosphere for 3 hours in total, namely, 1 hour at 80°C, 1 hour at 120°C, and 1 hour at 180°C, and then a polyimide insulation film having a thickness of about 50 nm is formed.

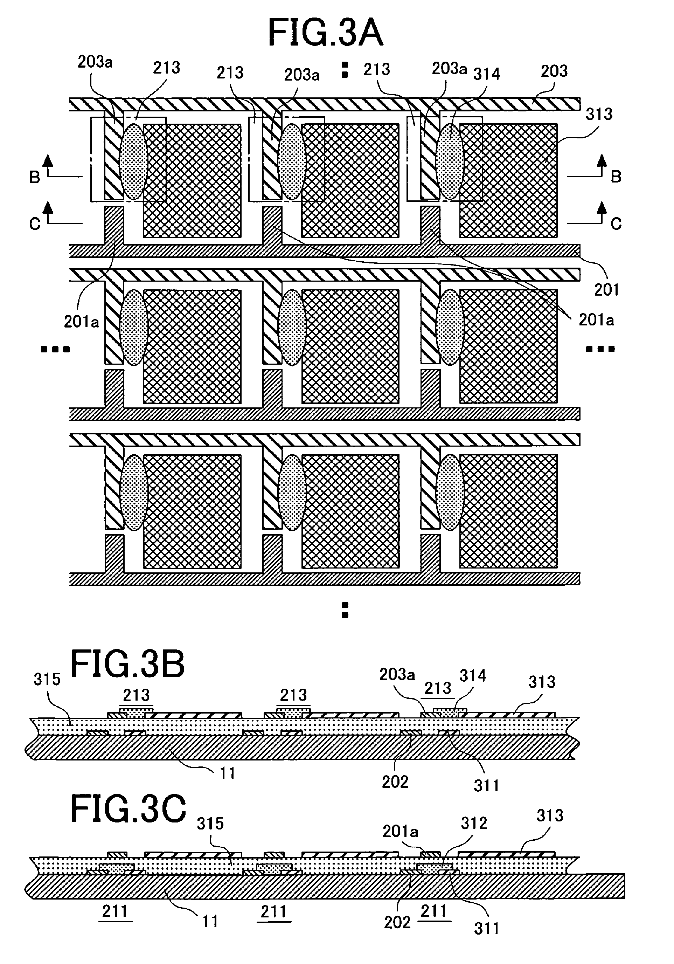

Next, as shown in Fig. 3A, the current supplying lines 203 and scanning lines 201, each having a width of about 50µm, are formed on the insulation film 315 with predetermined intervals by using the discharger (not shown), as similar to Fig. 2A. The interval between each current supplying line 203 and each scanning line 201 preferably corresponds to the size of a picture element. Further, the current supplying lines 203 and the scanning lines 201 are formed with a pattern in which branch wires, each having a width of about 50µm and a predetermined length, are attached while facing each other at the positions of the organic semiconductors 312 described in Fig. 2. The length of each branch wire 201a of the scanning line 201 is the length of the switch FET 211 shown in Fig. 2A. On the other hand, the length of each branch wire 203a of the current supplying line 203 is approximately the length obtained by subtracting the length of the switch FET 211 from the length of the wire 311 shown in Fig. 2A.

After forming the current supplying lines 203 and the scanning lines 201, counter electrodes 313 of organic EL elements are formed in parallel to the branch wires 201a of the scanning lines 201 and the branch wires 203a of the current supplying lines 203. In this case, the counter electrodes are preferably formed by, in place of the discharger, a method capable of high-speed and large-area printing, such as relief printing and surface printing due to large areas for electrodes. However, since the organic EL elements are current-driven elements, the counter electrodes 313 need not spread throughout the picture elements, and thus the size of the electrode 313 may be arbitrary as long as current at a degree where the organic EL elements can be driven can be applied. In this case, the printing methods such as the above are not necessary. In this embodiment, from the view point of simplicity that an apparatus for forming the electrodes is standardized, an area of 100µm times 300µm is coated with a silver ink by using the discharger so as to form the counter electrode 313.

Finally, the organic semiconductors 314 used as channels of the driving FETs 213 are dropped between each wire 203a added to the current supplying lines 203 and each counter electrode 313 of the organic EL elements by the discharger so as to obtain an active matrix picture element driving circuit. The interval between each branch wire 203a added to the current supplying lines 203 and each counter electrode 313 of the organic EL elements is set to 20µm, as similar to the case of the switch FET 211.

Fig. 3B is a cross sectional view that is viewed in the arrow direction at the B-B position of Fig. 3A. The data lines 202 and the wires 311 that are periodically formed in parallel on the quartz substrate 11 can be seen. However, the organic semiconductors 312 dropped so as to cross the both lines cannot be seen at this position. On the other hand, the branch wires 203a of the current supplying lines 203 and the counter electrodes 313 of the organic EL elements are formed on the insulation film 315, and the organic semiconductors 314 dropped so as to cross the wires 203a and the electrodes 313 can be seen. Attention should be paid to the fact that the wires 311 formed on the quartz substrate 11 are located at positions corresponding to the organic semiconductors 314. That is, the branch wires 203a corresponding to the sources and drains of the driving FETs 213 shown in Fig. 1 and the counter electrodes 313 of the organic EL elements are formed on the insulation film 315, whereas the gate electrodes are formed on the substrate 11 through the insulation film 315.

Fig. 3C is a cross sectional view that is viewed in the arrow direction at the C-C position of Fig. 3A. The data lines 202 and the wires 311 are periodically formed in parallel on the quartz substrate 11 and the organic semiconductors 312 dropped so as to cross the both lines can be seen. Attention should be paid to the fact that the branch wires 201a formed on the insulation film 315 are located at positions corresponding to the organic semiconductors 312. That is, the wires 202 and the wires 311 corresponding to the sources and drains of the switch FETs 211 shown in Fig. 1 are formed on the substrate 11, whereas the gate electrodes 201a are formed on the insulation film 315.

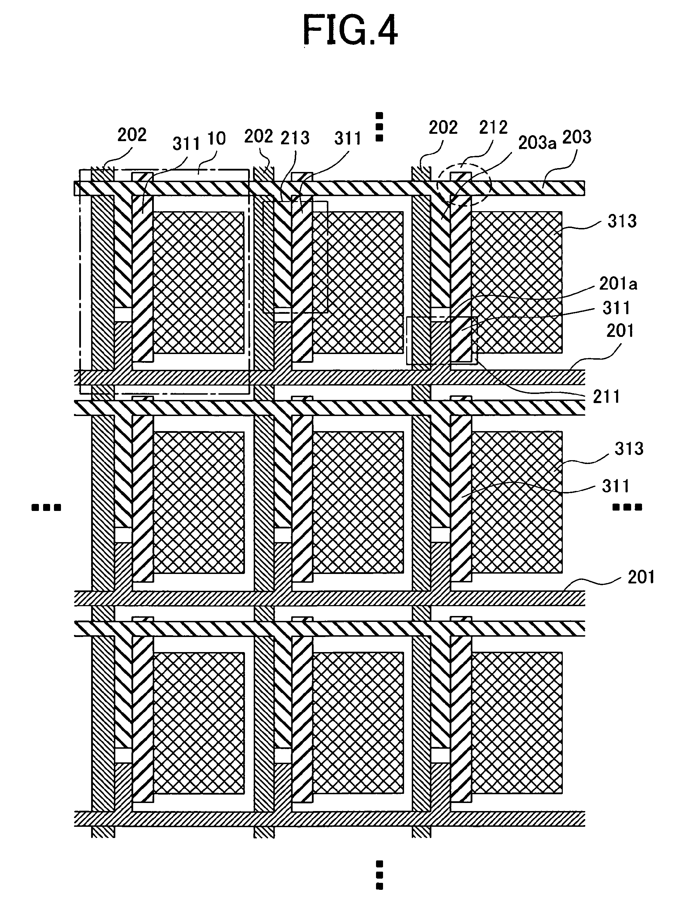

Fig. 4 is a plan view displaying all of the wiring pattern of the picture element driving circuits and the counter electrodes according to the first embodiment on a plane surface while paying attention thereto. Accordingly, the organic semiconductors configuring the channels of the FETs are not displayed. The data lines 202 that extend in the vertical axis direction are arranged with predetermined intervals, and the wires 311, each having a predetermined length, which also are used as the drain electrodes of the picture element lighting switch FETs 213 are arranged while providing predetermined intervals with respect to the data lines 202. The current supplying line 203 and the scanning line 201 make a pair, and are arranged with predetermined intervals in the horizontal axis direction orthogonal to the data lines 202. In addition, the branch wires 203a of the current supplying lines 203 and the branch wires 201a of the scanning lines 201 are arranged while being faced to each other between the data lines 202 and the wires 311. One end of each wire 311 reaches a position where it overlaps the current supplying line 203.

Accordingly, it can be found that the data lines 202, the wires 311, and the wires 201a, together with the organic semiconductors 312 shown in Fig. 3, form the switch FETs 211, and the current supplying lines 203, the counter electrodes 313, and the wires 311, together with the organic semiconductors 314 shown in Fig. 3, form the driving FETs 213. An area 212 where one end of each wire 311 overlaps the current supply line 203 forms the holding capacity 212 shown in Fig. 1. In order to make the capacity of the holding capacity 212 larger, the pattern of the area where one end of each wire 311 overlaps the current supplying line 203 is devised so as to make the overlapped area larger.

In this way, the areas configured by the data lines 202, the current supplying lines 203, the scanning lines 201, and the counter electrodes 313 configure the picture elements 10.

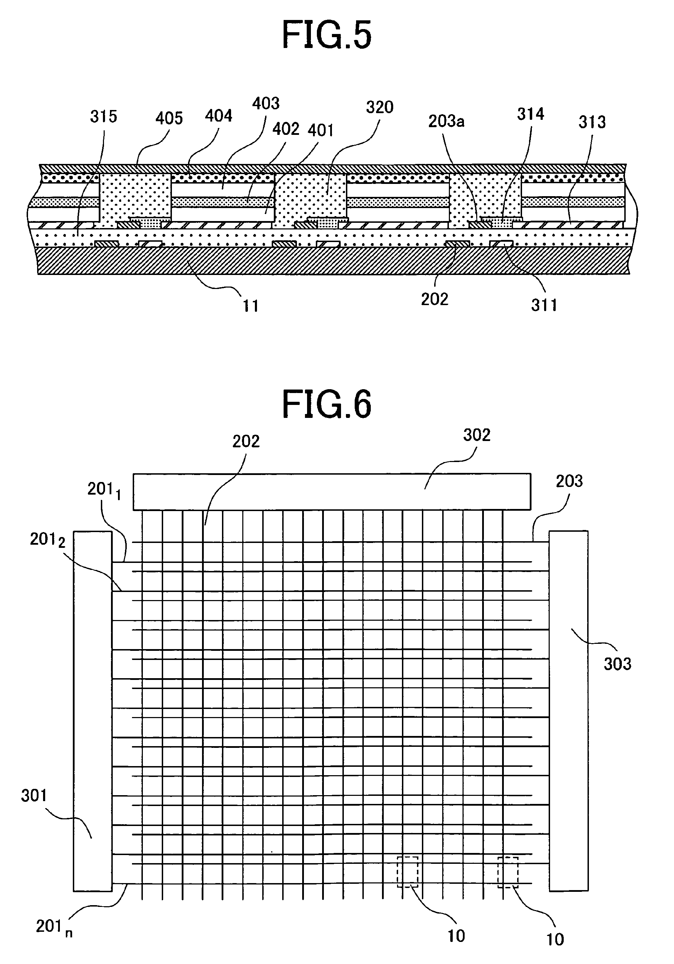

Fig. 5 is a schematic view of a completed display device, as a cross section that is viewed at a position corresponding to Fig. 3B. A hole injection layer 401, a hole transport layer 402, an emitting layer 403, and an electron transport layer 404, by all of which an organic EL layer is configured, are sequentially laminated on each counter electrode 313, each space between the display elements is filled with an insulation material 320, and then a transparent metal electrode 405 that is commonly used for all the display elements is laminated. In the present invention, it should be noted that the organic semiconductors for the switch FETs and the organic semiconductors for the driving FETs may be formed by using the same material or different materials.

Fig. 6 is a view showing a method of connecting the picture element driving circuit to peripheral circuits. As the peripheral circuits, there are provided a scanning line driving circuit 301, a data line driving circuit 302, and a current supplying line driving circuit 303. The scanning lines 201, the data lines 202, and the current supplying lines 203 are pulled out from the scanning line driving circuit 301, the data line driving circuit 302, and the current supplying line driving circuit 303, respectively. These driving circuits are formed on the substrate 11. As apparent from the explanations of Fig. 1 to Fig. 4, a pair of the scanning line 201 and the current supplying line 203, and the data lines 202 configure the picture element 10 of a unit.

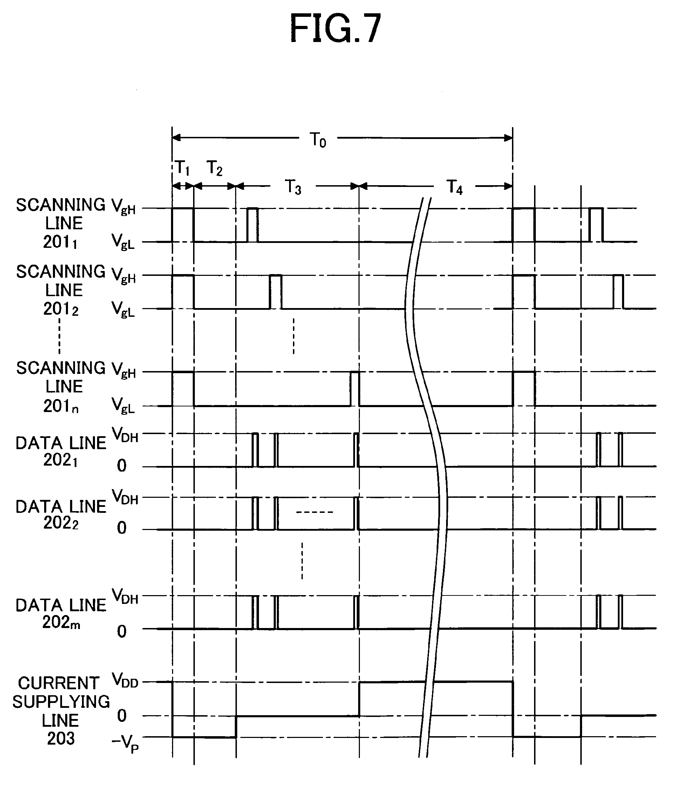

Fig. 7 is a time chart explaining an operation of the driving circuit. The scanning lines 201₁, 201₂, ..., 201ₙ are sequentially switched, and data are taken into the holding capacities 212 while the data lines 202₁, 202₂, ..., 202ₘ are turned on in accordance with the switching of the scanning lines. The numerals shown by subscripts are numbers sequentially assigned to the respective scanning lines 201 in Fig. 6 from the top, and are numbers sequentially assigned to the respective data lines 202 from the left to the right. In Fig. 7, a period shown by T₁ is a period during which charges accumulated in all the holding capacities are discharged, and a period shown by T₂ is a period during which holes accumulated in all the organic EL layers are allowed to disappear. A period shown by T₃ is a period during which the scanning lines 201 are switched and the data lines 202 are turned on. A period shown by T₄ is a period during which the organic EL layer is allowed to emit light in accordance with data accumulated in the holding capacities. A total period T₀ from T₁ to T₄ is a cycle period of display. The period T₄ is considerably long as compared to each of the other periods T₁ to T₃.

In the first embodiment, the discharger is mainly used as a coating and printing method, but the present invention is not apparently limited to this. An ink jet printer or a surface printer such as screen printing can be used in place of the discharger. The former has a characteristic that print heads can be easily integrated and large-area printing can be easily handled. Further, since the former is of a non-contact printing method, it can easily cope with irregularities of a substrate. Although high-accurate position adjustment is difficult in the surface printing, the surface printing has an advantage that large-area printing can be performed in a short period of time, as compared to the local coating technique used in the discharger and the ink jet printer. Further, the surface printing requires no precision devices such as a print head, and is high in failure resistance.

### (Second embodiment)

In the first embodiment, the wiring pattern shown in Fig. 2A is formed right above the substrate 11 to cover the whole pattern with the insulation film 315, and the wiring pattern shown in Fig. 3A is formed thereon to form two FETs. Thereafter, as shown in Fig. 5, the organic EL materials are provided between the counter electrodes 313 of the organic EL elements that are picture elements and the transparent common electrode 405 of the organic EL elements.

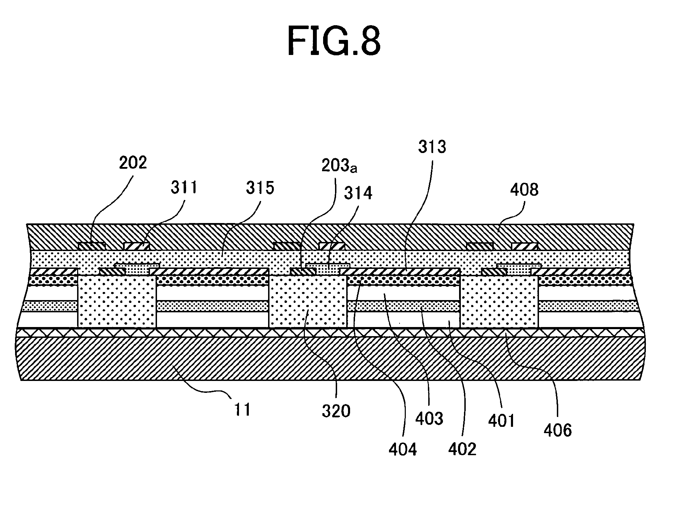

Fig. 8 is a schematic cross sectional view showing a configuration of a second embodiment corresponding to that of the first embodiment shown in Fig. 5. In the second embodiment, as shown in Fig. 8, after providing a common electrode 406 on the whole substrate 11, the hole injection layer 401, the hole transport layer 402, the emitting layer 403, and the electron transport layer 404, by all of which an organic EL layer is configured, are sequentially laminated, and each space between the display elements is filled with the insulation material 320. Thereafter, on the contrary to the first embodiment, as described with reference to Figs. 3A and 3B, the current supplying lines 203 and the scanning lines 201 are formed with predetermined intervals on the film surface configuring the organic EL layer and the insulation material 320. The interval between each current supplying line 203 and each scanning line 201 preferably corresponds to the size of a picture element. Further, the current supplying lines 203 and the scanning lines 201 are patterned with the branch wires added. After forming the current supplying lines 203 and the scanning lines 201, the counter electrodes 313 are formed at positions corresponding to the organic EL elements. Next, the organic semiconductors 314 used as channels of the driving FETs 213 are dropped by the discharger between the wires 203a added to the current supplying lines 203 and the counter electrodes 313 of the organic EL elements.

After the driving FETs 213 are formed by the current supplying lines 203, the scanning lines 201, and the organic semiconductors 314 and then the counter electrodes 313 are formed, the insulation film 315 is formed on the whole surface. Next, as described with reference to Figs. 2A and 2B, the switch FETs 211 corresponding to the scanning lines are formed by the data lines 202 and the wires 311, and by dropping the organic semiconductors 312.

Accordingly, since the organic EL layer is formed first in the second embodiment, the counter electrodes 313 connected to the driving FETs 213 are formed first, and then the switch FETs are formed.

### (Third embodiment)

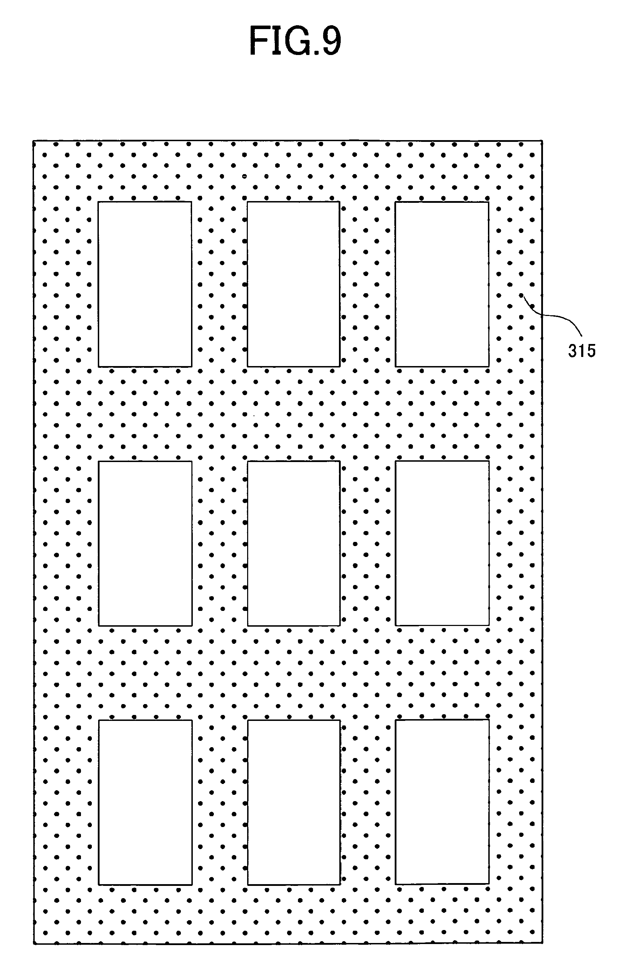

In the third embodiment, there will be explained an example in which the driving FETs are formed right above the substrate 11 and the switch FETs are formed thereon through the insulation film 315. Specifically, the wiring pattern shown in Fig. 3A is formed right above the substrate 11, and as shown in Fig. 9, this pattern is covered with the insulation film 315 in which portions corresponding to the counter electrodes 313 of the organic EL elements are opened. Then, the wiring pattern shown in Fig. 2A is formed thereon so as to form two FETs. That is, there is no problem even if any of two FETs is located nearer the substrate at the areas where two FETs are formed. However, if the counter electrodes 313 of the organic EL elements are located nearer the substrate 11 and the whole surface thereof is covered with the insulation film 315, the organic EL elements cannot be completed. Thus, there is required the insulation film 315 in which the areas corresponding to the counter electrodes 313 are opened. The other points may be the same as the first embodiment.

### [Fourth embodiment]

In the above described embodiments, the coatable organic semiconductors are used as the semiconductors, however, the configuration of the picture element driving circuit without through-holes is not limited thereto. As described in, for example, Nature, vol. 440, pp. 783-786 (2006), channels can be formed with polysilicon by heating and burning with the use of a silane-based coating solution. In this case, a heat treatment requires a relatively high temperature of 550°C. On the contrary, there is an advantage that a circuit can be designed without difficulty due to the high degree of carrier movement of the semiconductor and high deterioration-resistance. In addition, since the performance of the semiconductor is high, the picture quality of the display device can be easily enhanced.

Other than the coatable semiconductor, an amorphous silicon semiconductor can be used by using, for example, a silicon lamination layer formed by Chemical Vapor Deposition (CVD) as a semiconductor layer, which is disadvantageous in cost due to usage of a CVD vacuum process in the formation of the semiconductor and the necessity of photolithography. However, a fine circuit can be advantageously formed as compared to a coating/printing method.

According to the present invention, a circuit composed of two FETs can be formed without through-holes, and, as a result, a drilling process is not required. Thus, it is advantageous that the manufacturing process is shortened, the degree of freedom of selecting a material therefor can be enhanced, and the reliability of the product can be improved.

It is further understood by those skilled in the art that the foregoing description is a preferred embodiment of the disclosed device and that various changes and modifications may be made in the invention without departing from the spirit and scope thereof.

## Claims

1. An electric circuit comprising:
source and drain electrodes of a first thin film field-effect transistor which are formed on one surface of an insulation layer;
a first organic semiconductor which is provided between the source and drain electrodes of the first thin film field-effect transistor;
source and drain electrodes of a second thin film field-effect transistor which are formed on the other surface of the insulation layer; and
a second organic semiconductor which is provided between the source and drain electrodes of the second thin film field-effect transistor,
wherein one of the source and drain electrodes of the first thin film field-effect transistor is used as a gate electrode of a channel formed by the second organic semiconductor of the second thin film field-effect transistor.

2. An electric circuit comprising:
an insulation substrate;
source and drain electrodes of a first thin film field-effect transistor which are formed on a surface of the insulation substrate;
a first organic semiconductor which is provided between the source and drain electrodes of the first thin film field-effect transistor;
an insulation film which covers the first thin film field-effect transistor;
source and drain electrodes of a second thin film field-effect transistor which are formed on a surface of the insulation film; and
a second organic semiconductor which is provided between the source and drain electrodes of the second thin film field-effect transistor,
wherein one of the source and drain electrodes of the first thin film field-effect transistor is used as a gate electrode of a channel formed by the second organic semiconductor of the second thin film field-effect transistor.

3. A display device comprising:
an insulation substrate;
source and drain electrodes of a first thin film field-effect transistor which are formed on a surface of the insulation substrate;
a first organic semiconductor which is provided between the source and drain electrodes of the first thin film field-effect transistor;
an insulation film which covers the first thin film field-effect transistor;
source and drain electrodes of a second thin film field-effect transistor which are formed on a surface of the insulation film
a second organic semiconductor which is provided between the source and drain electrodes of the second thin film field-effect transistor;
an organic EL element electrode which is electrically connected to one of the source and drain electrodes of the second thin film field-effect transistor;
an organic EL layer which is laminated on the organic EL element electrode;
an insulation layer which fills between the organic EL layers; and
an organic EL element common electrode which is provided on a surface of the organic EL layer and a surface of the insulation layer,
wherein one of the source and drain electrodes of the first thin film field-effect transistor is used as a gate electrode of a channel formed by the second organic semiconductor of the second thin film field-effect transistor.

4. A display device comprising:
an insulation substrate;
an organic EL element common electrode which is formed on a surface of the insulation substrate;
an organic EL layer which is laminated on the organic EL element common electrode;
an insulation layer which fills between the organic EL layers;
source and drain electrodes of a first thin film field-effect transistor which are formed on a surface of the organic EL layer and a surface of the insulation layer;
a first organic semiconductor which is provided between the source and drain electrodes of the first thin film field-effect transistor;
an organic EL element electrode which is electrically connected to one of the source and drain electrodes of the first thin film field-effect transistor;
an insulation film which covers the first thin film field-effect transistor;
source and drain electrodes of a second thin film field-effect transistor which are formed on a surface of the insulation layer; and
a second organic semiconductor which is provided between the source and drain electrodes of the second thin film field-effect transistor,
wherein one of the source and drain electrodes of the second thin film field-effect transistor is used as a gate electrode of a channel formed by the first organic semiconductor of the first thin film field-effect transistor.

5. The display device according to claim 3,
wherein the order of forming the first thin film field-effect transistor and the second thin film field-effect transistor is reversed, and areas in the insulation film that covers the both the first and second thin film field-effect transistors, the areas being corresponding to the organic EL element electrodes, are opened.
